# EUROPEAN PATENT SPECIFICATION

(11) **EP 4 465 065 B1**
(45) Date of publication and mention of the grant of the patent: **14.10.2026**
(21) Application number: 24195950.1
(22) Date of filing: 18.10.2020
(51) Int. Cl.: H01R 43/048, G01R 31/66, G01R 31/69

(54) **METHOD TO DETERMINE QUALITY OF TERMINATION OF WIRE USING THERMAL CHARACTERISTICS**
VERFAHREN ZUR BESTIMMUNG DER QUALITÄT DES ABSCHLUSSES EINES DRAHTES UNTER VERWENDUNG THERMISCHER EIGENSCHAFTEN
PROCÉDÉ POUR DÉTERMINER LA QUALITÉ DE TERMINAISON DE FIL À L'AIDE DE CARACTÉRISTIQUES THERMIQUES

(30) Priority: 18.10.2019 US 201962923033 P
(43) Date of publication of application: 20.11.2024
(62) Document number(s) of the earlier application(s) in accordance with Art. 76 EPC: 20800725.2 / 4 046 245
(73) Proprietor: TE Connectivity Solutions GmbH, 8200 Schaffhausen (CH)
(72) Inventor: Dubler, Robert Allen, Middletown, PA 17057 (US); Orlowski, Matthew, Middletown, PA 17057 (US); Roberts, Jonathan, Cambridge, CB24 9NL (GB)
(74) Representative: Ashton, Gareth Mark

(56) References cited:
- CN-A- 105 319 221
- US-B2- 9 863 996
- OCOLEANU CONSTANTIN-FLORIN ET AL: "Design of a virtual intrument in LabVIEW for crimped connection temperature measurement", 2016 INTERNATIONAL CONFERENCE ON APPLIED AND THEORETICAL ELECTRICITY (ICATE), IEEE, 6 October 2016 (2016-10-06), pages 1 - 4, XP033003344, DOI: 10.1109/ICATE.2016.7754672
- DYCK TOBIAS ET AL: "The Influence of Contaminated Copper Wires on the DC Joule Heating of Connectors", 2018 IEEE HOLM CONFERENCE ON ELECTRICAL CONTACTS, IEEE, 14 October 2018 (2018-10-14), pages 17 - 23, XP033501100, DOI: 10.1109/HOLM.2018.8611711
- FLEISCHMANN HANS ET AL: "Distributed condition monitoring systems in electric drives manufacturing", 2016 6TH INTERNATIONAL ELECTRIC DRIVES PRODUCTION CONFERENCE (EDPC), IEEE, 30 November 2016 (2016-11-30), pages 52 - 57, XP033065286, ISBN: 978-1-5090-2908-2, [retrieved on 20170210], DOI: 10.1109/EDPC.2016.7851314

## Description

The invention relates to a method for monitoring the quality of a termination of a wire using thermal characteristics of the termination.

Wires are terminated using a variety of methods, such as, crimping, soldering or welding. For example, electrical terminals are typically crimped onto wires by a crimping apparatus to form a lead. The crimping apparatus has crimp tooling made up of a first part mounted to a base for supporting the electrical terminal and a second part mounted to a ram that is movable toward and away from the base for effecting the crimp. In operation, the terminal is placed on the first part of the crimp tooling and an end of a wire is inserted into the ferrule or barrel of the terminal. The ram is caused to move toward the base through a crimp stroke, thereby crimping the terminal onto the wire.

It would, therefore, be beneficial to provide a wire termination monitoring method which can be used to monitor different terminations of wires. In particular, it would be beneficial to provide a wire termination monitoring system and method which does not solely measure force or dimensions, but monitors the thermal characteristics of the termination.

The paper "Design of a virtual intrument in LabVIEW for crimped connection temperature measurement" by Constantin-Florin Ocoleanu et al given at the 2016 International Conference on Applied and Theoretical Electricity (IEEE, 6 October 2016, pages 1-4) discloses a method of measuring the temperature of a crimped connection with a sensor. The measured value is saved and compared with a reference value in order to assess the quality of the crimped connection.

According to the present invention there is provided a method of determining the quality of a termination of a wire as claimed in claim 1.

A crimping apparatus is provided which allows for determining the quality of a crimp. The apparatus includes an applicator which has an anvil and a crimp tool which is movable relative to the anvil, The anvil and a crimp tool define a crimping zone of the apparatus. A thermal sensor is mounted on the crimping apparatus proximate the applicator. The thermal sensor monitors the thermal properties of the crimp made by the applicator to determine if the crimp is defective.

The invention will now be described by way of example with reference to the accompanying drawings in which:
FIG. 1 is a perspective view of an illustrative crimping apparatus using thermal sensors to monitor the quality of crimp.
FIG. 2 is a flowchart illustrating an illustrative method of monitoring the quality of a wire termination using thermal properties.

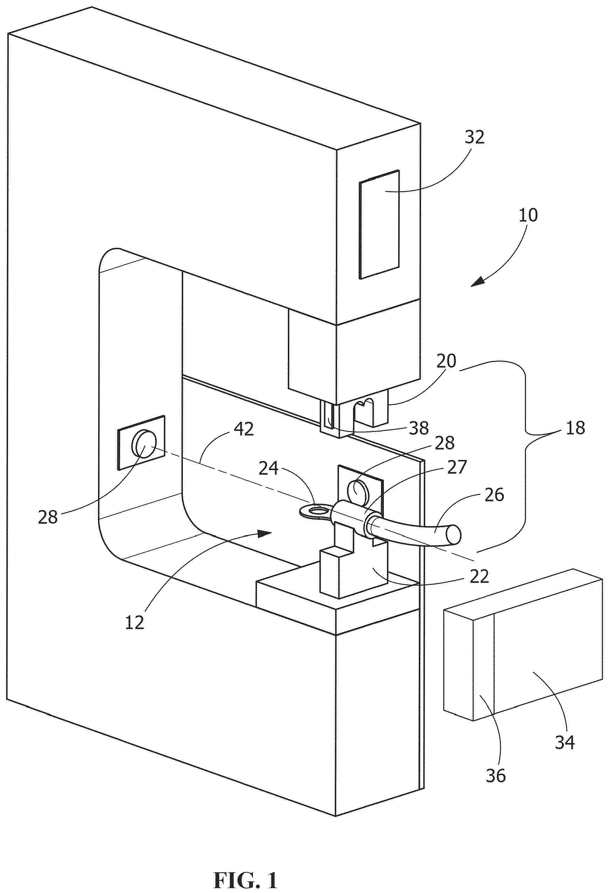

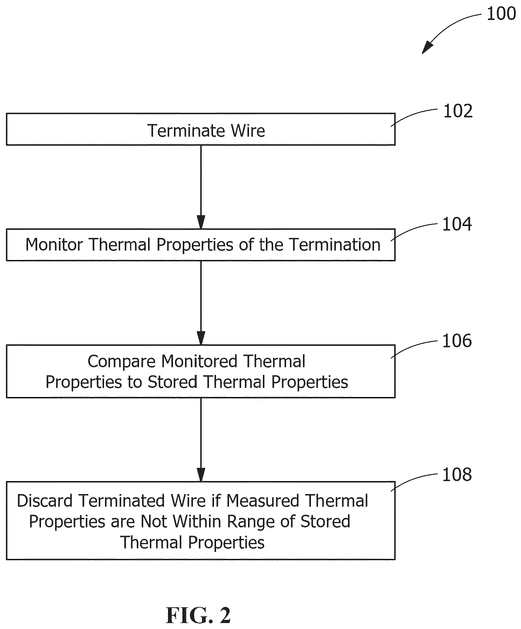

A device (FIG. 1) and method of monitoring the crimping processes (FIGS. 2 and 3) for the purpose of determining crimp quality by using thermal characteristics and signatures is shown. However, the use of the crimping machine is meant to be illustrative and not limiting. The use of thermal data and analysis, as described below, to monitor the termination of wires, conductors or terminals has other uses beyond just crimp related applications.

FIG. 1 is a perspective view of a crimping machine 10 having an applicator 12. The crimping machine 10 is illustrated as a terminal crimping machine used for crimping terminals to wires, however, other types of machines may be used, such as an insulation displacement connector (IDC) machine, a welding machine, and the like, that attach connectors to wires using processes other than crimping. Alternatively, the crimping machine 10 may be another type of crimping machine such as a lead frame machine.

The applicator 12 is coupled to the crimping machine 10. The applicator 12 may be removed and replaced with a different applicator, such as when the applicator 12 is worn or damaged or when an applicator having a different configuration is desired. The applicator 12 has a terminating zone or crimping zone 18 and includes a crimper or crimp tooling 20 and an anvil 22 as the mechanical tooling for crimping electrical connectors or terminals 24 to an end of a wire 26 in the crimping zone 18. The anvil 22 is a stationary component of the applicator 12, and the crimp tooling 20 represents a movable component.

One or more thermal sensors 28 are mounted to the crimping machine 10. The thermal sensors 28 may be mounted at various locations in or proximate to the crimping zone 18. The thermal sensors 28 may be removably mounted by a removable device, such as, but not limited to, a magnet (not shown). Alternatively, the thermal sensors 28 may be held in place by using mechanical fasteners, latches, adhesives, and the like. While the thermal sensors 28 are shown circular members, the thermal sensors 28 may have other shapes.

In an exemplary embodiment, each of the thermal sensors 28 are positioned to have a field of view that includes the crimping zone 18. The thermal sensors 28 are positioned to acquire the thermal characteristics, in the form of discrete thermal data, of the terminal 24 and/or the wire 26 in the crimping zone 18. In an embodiment, at least one of the thermal sensor 28 is positioned in-line with a longitudinal axis 42 of the anvil 22 and a barrel 27 of the terminal 24. This allows the thermal sensor 28 to directly sense and collect the thermal data from the thermal energy that is emitted directly from the terminal 24 and/or the wire 26. One or more of the thermal sensors 28 are positioned out-of-line or off-center from the axis 42 so that those thermal sensors 28 may collect thermal energy that is transferred through the terminal 24 to the wire 26 or to another object and/or those thermal sensors 28 may collect thermal energy which is reflected off the terminal 24 and/or the wire 26.

For example, positioning bodies or objects around the terminal 24 and/or wire 26 which are configured to intentionally reflect or direct thermal energy from the terminal 24 and/or the wire 26 being sensed would allow a thermal sensor 28 to be out-of-line or off-center from the terminal 24 and read thermal data that is reflected from the surrounding bodies or objects. Construction of these surrounding bodies could be done with materials of known emissivity to enhance the reflected imaging of the thermal characteristics of the terminal 24 and/or the wire 26 being terminated. This would allow the ability to thermally "sense" areas that would not be easy viewed or to view more surface area of the terminal 24 and/or the wire 26 with fewer sensors.

As previously stated, the thermal data collected by the one or more thermal sensors 28 may be one or a combination of three distinct components of energy. The first is thermal energy emitted directly from the terminal 24 and/or the wire 26. The second is thermal energy that is transferred through the object (heat from somewhere else that passes through) such as from the terminal 24 to the wire 26. The third is thermal energy reflected off the terminal 24 and/or the wire 26.

In one exemplary embodiment, the thermal data is captured by a plurality of sensors 28 arranged in a matrix (such as a charge coupled device network) which allows the thermal data to be captured and arranged in rows and columns - similar to how pixels of data describe a visual image collected with a conventional visual energy camera. For example, one thermal sensor may be positioned in-line with the longitudinal axis of the of the terminal, while other thermal sensors of the matrix may be positioned out-of-line or off-center from the axis. Due to the number of data points, techniques, such as but not limited to, an adapted convolution neural network, are used to extract features from these matrices of data to analyze the process of a crimp before, during and after the crimp has been formed. These features are apparent in particular regions of interest on the terminal 24 and/or the wire 26 and form the basis of categorization of the termination.

The characteristics and signatures of the thermal data collect may include, but are not limited to: i) area heating; ii) heat transfer times; iii) heat transfer patterns; iv) temperature delta v) physical characteristics and variations identified through thermal properties.

In addition, the thermal data can be collected at various rates, which results in a time series of images. Using analysis techniques, such as, but not limited to artificial intelligence, the time varying data can be analyzed.

In various illustrative examples, the thermal sensors 28 have the ability to collect absolute temperatures. Absolute temperatures provide the potential for not just analyzing "relative" regions of interest but potentially distinct mechanical characteristics of the termination.

A display device 32 may be communicatively coupled to the thermal sensor 28 and configured to display the thermal characteristics acquired by the thermal sensor 28. The display device 32 may be integrated into a host controller or processor of the crimping machine 10 itself or may be a separate controller or processor 34, such as a desktop computer, a laptop computer, a tablet computer, a monitor, a projector, and the like. Optionally, the display device 32 may be a crimp quality monitor (CQM) device. The controller 34 and/or display device 32 may be coupled to the thermal sensor 28 through a cable or the like. Alternatively, the controller 34 and/or display device 32 may communicate wirelessly through induction, radio frequency waves, Wi-Fi, and the like to transmit data between the thermal sensor 28 and the controller 34 and/or display device 32.

The controller 34 and/or display device may include a storage or memory device 36 such as, but not limited to, a hard disk drive, RAM, ROM, and/or another internal data storage device. The memory device 36 may be configured to store data acquired by the thermal sensor 28. Such data may be used for subsequent quality reporting purposes.

In various examples, the crimping machine 10 may include additional sensors 38, such as, but not limited to, a force sensor or a linear sensor to provide additional data with respect to the quality of the crimp.

During a crimping operation, the crimp tooling 20 is driven initially towards the stationary anvil 22 and finally away from the anvil 22, as represented by 102 in FIG. 2. FIG. 2 illustrates the method of determining the quality of a termination 100. Thus, the crimp stroke has both a downward component and an upward component. The crimping of the terminal 24 to the wire 26 occurs during the downward component of the crimp stroke. The crimp tooling 20 engages the terminal 24 and crimps the terminal 24 onto the wire 26 by compressing the terminal 24 between the crimp tooling 20 and the anvil 22. As this occurs, thermal energy or heat is produced in the terminals and the wires within and proximate to the crimp.

As previously stated, the thermal sensors 28, either directly from thermal sensors 28 positioned in line with the axis 42 or indirectly from thermal sensors positioned out-of-line or off-center from the axis 42, may acquire temperature measurements/data at designated intervals or continuously of the terminals 24 and the end of the wire 26 positioned in the crimping zone 18, as represented by 104 in FIG. 2. The collected temperature measurements/data is transmitted to the display device 32, the controller 34 or the memory device 36, either on the crimping machine 10 or at an external location from the crimping machine 10. The temperature measurements/data transmitted by the thermal sensor 28 is used by an operator of the crimping machine 10 to be able to determine if the termination of the wire meets appropriate standards to provide the desired electrical and mechanical connection. The terms "operator" is used herein to identify the machine or person operating or controlling the crimping machine 10.

By monitoring the temperature of the terminal 24, either directly or indirectly, the quality of the crimp may be monitored 18. By analyzing the temperature of the terminal 24, either directly or indirectly, other characteristics of the crimp may be analyzed. For example, the temperature may be used to calculate the forces imported onto the terminal 24, as the amount of force is related to the temperature of the terminal 24 after crimping has occurred.

In operation, after the movement of the crimp tooling from the closed position back toward the open position is detected, the sensors 28 are activated and send data to the controller 34.

In an exemplary embodiment, as represented by 104 in FIG. 2, the thermal characteristics of the crimp are measured, either directly or indirectly, during the crimp stroke by the one or more thermal sensors 28. The thermal characteristics are measured at predetermined intervals based on either time or crimp tooling position. For example, a predetermined sample time may be selected, and the thermal characteristics may be measured at each of the discrete sample times. Alternatively, or additionally, the thermal characteristics may be measured when the crimp tooling is at a predetermined crimp height position. The position of the crimp tooling may be detected by a distance sensor (not shown) or the like.

The controller 32 may create a measured temperature profile of the crimp based on the measured thermal characteristics. The measured thermal profile is then compared to an acceptable temperature profile or an acceptable temperature profile range of known successful crimps, as represented by 106 in FIG. 2. Alternatively, the measured thermal characteristics may be compared to known acceptable temperature characteristics or profiles of the particular materials being used. The acceptable temperature profile or an acceptable temperature profile range may be preinstalled in the controller 32 or may be developed by the user on-site and stored in the controller 32. If the measured temperature profile is within the acceptable temperature profile range, the controller 32 will indicate that the crimp is proper. If the measured temperature profile is not within the acceptable temperature profile range, the controller 32 will indicate that the crimp is not acceptable and reject the crimp, as represented by 108 in FIG. 2. Data relating to the thermal characteristics, the peak temperature, the amount of area below the temperature curve, the shape of the temperature curve, or any combination may be analyzed to determine if the crimp is defective.

The use of thermal data and analysis to monitor the termination of wires or conductors has other uses beyond just crimp related applications. For example, thermal analysis of welds (ultrasonic, resistive, etc.), molding, stamping, thermoplastic welding and heat staking (plastic riveting) is beneficial to determine if a proper electrical connection has been secured. In addition to collecting thermal data directly after the terminal has occurred to determine if a proper termination has been affected, the thermal sensors may be used to collect thermal data during the termination process, allowing the controller to continue the terminal process until such time that a good termination/connection is achieved.

By collecting thermal data during the crimping process, either by non-contact methods such as thermal sensors or by direct contact thermal sensors or both the data can be used to provide a quality assessment without the need for destructive testing. In fact, the thermal data can be used to create nondestructive 3D thermal cross sectioning. The use of the thermal data is beneficial in many applications, particularly in applications in which there is very little force variation between crimping a terminal with a wire or crimping one without a wire, for example, when crimping aluminum wire.

A wire terminating apparatus is provided which allows for determining the quality of a termination of a wire, the apparatus comprising: a wire termination zone; a thermal sensor mounted on the wire terminating apparatus proximate the wire termination zone; wherein the thermal sensor monitors the thermal properties of the termination to determine if the termination is defective.

Multiple thermal sensors are mounted on the wire terminating apparatus proximate the wire termination zone.

Preferably the thermal sensor is removably mounted to the wire terminating apparatus.

Preferably the thermal sensor is positioned to have a field of view of the wire termination zone.

Preferably the thermal sensor is positioned in line with a longitudinal axis of the wire positioned in the wire termination zone.

One thermal sensor is positioned off centered from a longitudinal axis of a wire positioned in the wire termination zone, wherein the thermal sensor monitors the thermal properties of the termination which are reflected.

Preferably the wire termination zone has an anvil and a crimp tool which is movable relative to the anvil, the anvil and a crimp tool defining a crimping zone of the wire terminating apparatus.

Preferably the wire termination zone is a heating zone.

While the invention has been described with reference to a preferred embodiment, it will be understood by those skilled in the art that various changes may be made without departing from the scope of the invention as defined in the accompanying claims. One skilled in the art will appreciate that the invention may be used with many modifications of structure, arrangement, proportions, sizes, materials and components and otherwise used in the practice of the invention, which are particularly adapted to specific environments and operative requirements without departing from the present invention. The presently disclosed embodiments are therefore to be considered in all respects as illustrative and not restrictive, the scope of the invention being defined by the appended claims, and not limited to the foregoing description or embodiments.

## Claims

1. A method of determining quality of a termination of a wire (26) including:
(i) terminating the wire (26) with a terminal (24);
(ii) monitoring thermal properties of this termination with multiple thermal sensors (28) mounted on a wire terminating apparatus (10) proximate a wire termination zone (18) thereof, one said thermal sensor (28) being positioned off-centered from a longitudinal axis (42) of the wire (26) positioned in the wire termination zone (18); and
(iii) comparing the monitored thermal properties to stored thermal properties to determine if the termination is defective.

2. The method of claim 1, wherein the termination is a crimped termination.

3. The method of claim 1 or 2, wherein one said thermal sensor (28) is positioned in line with a longitudinal axis (42) of the wire (26) positioned in the wire termination zone (18).

4. The method of claim 1, 2 or 3, wherein the off-centered thermal sensor (28) collects thermal energy which is reflected off at least one of the terminal (24) and the wire (26)

5. The method of claim 3 or 4, wherein plural said thermal sensors (28) acquire temperature measurements at designated intervals or continuously.

6. The method of claim 5 when dependent on claim 2, wherein the intervals are based on time.

7. The method of claim 5 when dependent on claim 2, wherein the intervals are based on crimp tooling (20) position.

8. The method of claim 1, wherein the termination is a weld termination.

9. The method of claim 1, wherein the termination is an insulation displacement termination.

## Patentansprüche

1. Verfahren zum Bestimmen der Qualität eines Abschlusses eines Drahts (26), das Folgendes beinhaltet:
(i) Abschließen des Drahts (26) mit einer Klemme (24);
(ii) Überwachen der thermischen Eigenschaften dieses Abschlusses mit mehreren Wärmesensoren (28), die an einer Drahtabschlussvorrichtung (10) in der Nähe einer Drahtabschlusszone (18) davon montiert sind, wobei ein genannter Wärmesensor (28) außermittig zu einer Längsachse (42) des in der Drahtabschlusszone (18) positionierten Drahts (26) positioniert ist; und
(iii) Vergleichen der überwachten thermischen Eigenschaften mit gespeicherten thermischen Eigenschaften, um festzustellen, ob der Abschluss fehlerhaft ist.

2. Verfahren nach Anspruch 1, wobei der Abschluss ein gecrimpter Abschluss ist.

3. Verfahren nach Anspruch 1 oder 2, wobei ein genannter Wärmesensor (28) in einer Linie mit einer Längsachse (42) des in der Drahtabschlusszone (18) positionierten Drahts (26) positioniert ist.

4. Verfahren nach Anspruch 1, 2 oder 3, wobei der außermittige Wärmesensor (28) Wärmeenergie erfasst, die von der Klemme (24) und/oder dem Draht (26) reflektiert wird.

5. Verfahren nach Anspruch 3 oder 4, wobei mehrere genannte Wärmesensoren (28) Temperaturmesswerte in festgelegten Intervallen oder kontinuierlich erfassen.

6. Verfahren nach Anspruch 5 wenn abhängig von Anspruch 2, wobei die Intervalle auf Zeit basieren.

7. Verfahren nach Anspruch 5 wenn abhängig von Anspruch 2, wobei die Intervalle auf der Position des Crimpwerkzeugs (20) basieren.

8. Verfahren nach Anspruch 1, wobei der Abschluss ein Schweißabschluss ist.

9. Verfahren nach Anspruch 1, wobei der Abschluss ein Isolationsverschiebungsabschluss ist.

## Revendications

1. Procédé de détermination de la qualité d'une terminaison d'un fil (26) incluant :
(i) le fait de terminer le fil (26) avec une borne (24) ;
(ii) le fait de surveiller des propriétés thermiques de cette terminaison à l'aide de multiples capteurs thermiques (28) montés sur un appareil de terminaison de fil (10) à proximité d'une zone de terminaison de fil (18) de celui-ci, un capteur thermique précité (28) étant positionné de manière décentrée par rapport à un axe longitudinal (42) du fil (26) positionné dans la zone de terminaison de fil (18) ; et
(iii) le fait de comparer les propriétés thermiques surveillées avec des propriétés thermiques stockées afin de déterminer si la terminaison est défectueuse.

2. Procédé de la revendication 1, dans lequel la terminaison est une terminaison sertie.

3. Procédé de la revendication 1 ou 2, dans lequel un capteur thermique précité (28) est positionné en ligne avec un axe longitudinal (42) du fil (26) positionné dans la zone de terminaison de fil (18).

4. Procédé de la revendication 1, 2 ou 3, dans lequel le capteur thermique décentré (28) collecte l'énergie thermique qui est réfléchie depuis au moins un élément parmi la borne (24) et le fil (26).

5. Procédé de la revendication 3 ou 4, dans lequel plusieurs capteurs thermiques précités (28) acquièrent des mesures de température à des intervalles désignés ou de manière continue.

6. Procédé de la revendication 5 lorsqu'elle est dépendante de la revendication 2, dans lequel les intervalles sont basés sur le temps.

7. Procédé de la revendication 5 lorsqu'elle est dépendante de la revendication 2, dans lequel les intervalles sont basés sur une position de l'outillage à sertir (20).

8. Procédé de la revendication 1, dans lequel la terminaison est une terminaison de soudage.

9. Procédé de la revendication 1, dans lequel la terminaison est une terminaison audodénudante.
